# EUROPÄISCHE PATENTSCHRIFT

(11) **EP 0 752 165 B1**
(45) Veröffentlichungstag und Bekanntmachung des Hinweises auf die Patenterteilung: **15.07.1998**
(21) Anmeldenummer: 95913026.1
(22) Anmeldetag: 14.03.1995
(51) Int. Cl.: H01S 3/19, H01L 33/00, H01L 31/0352

(54) **QUANTENSCHICHTSTRUKTUR**
QUANTUM-LAYER STRUCTURE
STRUCTURE EN COUCHES QUANTIQUES

(30) Priorität: 25.03.1994 DE 4410240; 20.05.1994 DE 4417798
(43) Veröffentlichungstag der Anmeldung: 08.01.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: BACHEM, Karl-Heinz, D-79199 Kirchzarten (DE); FEKETE, Dan, Haifa (IL)
(74) Vertreter: Münich, Wilhelm, Dr.
(86) Internationale Anmeldenummer: DE9500353
(87) Internationale Veröffentlichungsnummer: WO9526585

(56) Entgegenhaltungen:
- EP-A- 0 416 879
- EP-A- 0 610 893
- DE-A- 4 422 220
- CONFERENCE ON LASERS AND ELECTRO-OPTICS (CLEO 1991) TECHNICAL DIGEST SERIES VOL 10, PROCEEDINGS OF THE CONFERENCE MAY 12-17 1991 BALTIMORE MARYLAND U.S. Seiten 334 - 335, XP000359799 J.H. LEE ET AL 'Monolayer thick GaAs-GaAsSb strained layer quantum well lasers'
- APPLIED PHYSICS LETTERS., Bd.60, Nr.25, 22. Juni 1992, NEW YORK US Seiten 3087 - 3089 E. LUGAGNE-DELPON ET AL 'Observation of laser emission in an InP-AlInAs type II superlattice'
- PATENT ABSTRACTS OF JAPAN vol. 9, no. 27 (E-294) 6. Februar 1985 & JP,A,59 172 785 (NIPPON DENKI KK)
- SOVIET TECHNICAL PHYSICS LETTERS, Bd.12, Nr.6, Juni 1986, NEW YORK US Seiten 275 - 277 A.N. BARANOV ET AL 'Quantum well laser with a single heterojunction'
- APPLIED PHYSICS LETTERS., Bd.61, Nr.16, 19. Oktober 1992, NEW YORK US Seiten 1962 - 1964 M.C. PHILLIPS 'Proposal and verification of a new visible light emitter based on wide band gap II-VI semiconductors'
- JOURNAL OF CRYSTAL GROWTH., Bd.127, Nr.1/4, August 1993, AMSTERDAM NL Seiten 241 - 245 J.-Y. EMERY ET AL 'Gas source molecular beam epitaxy of alternated tensile/compressive strained GaInAsP multiple quantum wells emitting at 1.5 mum'
- APPLIED PHYSICS LETTERS., Bd.59, Nr.19, 4. November 1991, NEW YORK US Seiten 2360 - 2362 A.N. BARANOV ET AL 'linewidth enhancement factor for GaInSbAs/GaSb' in der Anmeldung erwähnt

## Beschreibung

### Technisches Gebiet

Die Erfindung bezieht sich auf eine Quantenschichtstruktur für Laser oder Detektoren, mit mindestens vier Halbleiterschichten (S1, S2, S3, S4), wobei zwischen zwei äußeren Barrierenschichten (S1, S4) mindestens zwei innere Schichten (S2, S3) angeordnet sind, ohne Anlegen einer elektrischen Spannung die Leitungsbandunterkante einer der inneren Schichten ein absolutes Minimum in der Leitungsbandunterkante hinsichtlich aller Schichten in der Quantenstruktur und die Valenzbandoberkante einer weiteren inneren Schicht ein absolutes Maximum in der Valenzbandoberkante hinsichtlich aller Schichten in der Quantenstruktur aufweist, und zumindest die beiden inneren Schichten, die das absolute Minimum und das absolute Maximum aufweisen, quantisierte Löcher- bzw. Elektronenzustände aufweisen,

Die Quantenschichtstrukturen bestehen aus Schichten verschiedener Verbindungen, deren Emissions bzw. Absorptionswellenlänge durch die erfindungsgemäße Beschichtung größer ist als die Emissions bzw. Absorptionswellenlänge der Verbindungen selbst. Werden die erfindungsgemäßen Quantenschichtstrukturen auf Galliumarsenidsubstraten aufgebracht, so sind Wellenlängen von 1,3 µm oder auch höher möglich. Bei Verwendung von InP-Substraten sind Wellenlängen im Bereich zwischen ungefähr 2 µm und 5 µm möglich. Geeignet sind derartige Quantenschichtstrukturen z.B. als Halbleiterinjektionslaser, Modulatoren und Detektoren insbesondere auch photovoltaische Detektoren (siehe z.B. Y. Sugiyama et al., J. Cryst. Growth, 95, 1989, 263-366).

### Stand der Technik

Bei Betrachtung der Verlustfunktion einer Glasfaser ist festzustellen, daß minimale Verluste bei 1,3 µm und 1,55 µm Wellenlänge zu beobachten sind. Siehe dazu z.B. S. M. Sze in Physics of Semiconductor Devices, 2^{nd} Edition (1981), 704. Der Spektralbereich um 1,3 µm ist der international standardisierte Wellenlängenbereich für die optischen Nachrichtenübertragungen über Glasfaserübertragungsstrecken. Es wird erwartet, daß dieser, die großen Netze der nationalen und international operierenden Fernmeldeorganisationen beherrschende Spektralbereich sich bis zu den privaten Nachrichtenkonsumenten ausbreiten wird ("Fibre to the Home"). Optoelektronische Bauelemente für diesen Spektralbereich sind darum von besonderer technischer Bedeutung.

Optoelektronische Bauelemente, wie z.B. Laser, Detektoren und Modulatoren für den Spektralbereich von 1,3 µm werden heute ausnahmslos auf Indiumphosphitsubstraten hergestellt.

Der mittelwellige Infrarotbereich (2-5µm) ist für den laserspektroskopischen Nachweis von Spurengasen in der Atmosphäre von erheblicher technischer Bedeutung, weil fast alle infrarotaktiven Gase in diesem Wellenlängenbereich mehr oder weniger starke Absorptionsbanden haben. Diese Anwendung wird "Environmental Monitoring" genannt. Für diese Anwendung setzt man heutzutage Bleisalzlaserdioden ein. Selbst nach 20-jähriger Entwicklungszeit sind diese Bauelemente immer noch in einem schlechten technischen Zustand. Sie müssen auf tiefe Betriebstemperatur abgekühlt werden, das Modemspektrum ist instabil und die Zuverlässigkeit befriedigt nur sehr geringe anwendungstechnische Standards.

Um den Wellenlängenbereich von 1,3 µm zu erreichen, wären andere Materialkombinationen, wie z.B. GaₓIn₁₋ₓAs_{y}P_{1-y}, GaAsₓSb₁₋ₓ , InAsₓP₁₋ₓ, (AlₓGa₁₋ₓ)_{y}In_{1-y} As oder InₓGa₁₋ₓ As, wobei x und y von 0 bis 1 variiert werden können, bei Betrachtung der zugehörigen fundamentalen Bandlücken und den damit korrespondierenden Wellenlängen aussichtsreiche Kandidaten. Die Technologie dieser Bauelemente ist allerdings schwierig und die technisch wünschenswerte Integration mit komplexen elektronischen Schaltkreisen auf dem gleichen Substrat ist trotz erheblichen internationalen Forschungsanstrengungen nicht gelungen.

Die längste, bisher bei einem Laser auf Galliumarsenidsubstraten erreichte Emissionswellenlänge liegt bei ca. 1,1 µm. Die aktive Schicht dieser Laser ist eine mechanisch verspannte Quantenschichtstruktur aus Galliumindiumarsenid (P.K. York et al, Journal of Crystal Growth 107 (1991) 741). Eine nennenswert längere Emissionswellenlänge ist mit dieser Struktur aus prinzipiellen Gründen nicht zu erreichen.

In der Veröffentlichung "Linewidth enhancement factor for GaInSbAs/GaSb lasers", A. N. Baranov, Appl. Phys. Lett. **59** (1991), 2360 wird eine Heterolaserstruktur offenbart, bei der an einem pn-Übergang durch Betrieb des Lasers eine Bandverbiegung erreicht wird, in der lokalisierte Löcher und Elektronen miteinander strahlend rekombinieren können. Erst durch die Bandverbiegung kommt es zur Quantelung von Elektron- bzw. Lochenergien im Bereich der Bandverbiegung. D.h. daß bei schwacher Strominjektion existiert keine Quantelung.

Die verwendeten Halbleitermaterialien können nur auf einem GaSb-Substrat gitterangepaßt aufgebracht werden. Sie sind also für die technisch relevanten Substrate, wie insbesondere GaAs nicht zugänglich.

Der vorgestellte Laser hat weiterhin den Nachteil, daß ein hoher Schwellstrom verwendet werden muß, um den Laservorgang zu starten. Alle zur Optimierung von Laserstrukturen bekannten Techniken, wie z.B. Erniedrigung des Schwellstromes, Erhöhung der Modulationsgeschwindigkeit und der Leistung, können auf die von Baranov vorgestellte Laserstruktur nicht angewendet werden, da ein pn-Übergang verwendet worden ist. Ferner kommt es im Pulsbetrieb bei diesem Laser zu einem starken Frequenzjitter.

Aus einem Artikel von J.H. Lee et al., "Monolayer thick GaAs-GaAsSb strained layer quantum well lasers", Conference on Lasers and electro-optics (CLEO 1991), Technical digest series Vol. 10, Proceedings of the conference May 12-17, 1991 Baltimore/Maryland, p. 334-335, geht ein auf Ga-Basis aufgebauter mit Quantumwell-Schichten versehener Laser hervor, der zur Erzeugung längerer Emissionswellenlängen gezielt mit Arsen dotiert wird.

### Darstellung der Erfindung

Die Erfindung hat die Aufgabe Quantenschichtstrukturen vorzustellen, die eine Verringerung der Emissions bzw. Absorptionsenergie bzw. Erhöhung der Emissions- bzw. Absorptionswellenlänge im Vergleich zu herkömmlichen Quantenschichtstrukturen ermöglichen. Dabei ist es eine weitere Aufgabe der Erfindung, technische Geräte wie Laser oder Detektoren anzugeben, die sich durch einen geringen Schwellstrom, eine hohe Leistung und eine hohe Modulationsgeschwindigkeit auszeichnen.

Die Lösung der der Erfindung zugrundeliegenden Aufgabe ist im Anspruch 1 angegeben. Den Erfindungsgedanken vorteilhaft weiterbildende Merkmale sind Gegenstand der Unteransprüche.

Erfindungsgemäß ist eine Quantenschichtstruktur für Laser oder Detektoren, mit mindestens vier Halbleiterschichten, wobei zwischen zwei äußeren Barrierenschichten mindestens zwei innere Schichten angeordnet sind, ohne Anlegen einer elektrischen Spannung die Leitungsbandunterkante einer der inneren Schichten ein absolutes Minimum in der Leitungsbandunterkante hinsichtlich aller Schichten in der Quantenstruktur und die Valenzbandoberkante einer weiteren inneren Schicht ein absolutes Maximum in der Valenzbandoberkante hinsichtlich aller Schichten in der Quantenstruktur aufweist, und zumindest die beiden inneren Schichten, die das absolute Minimum und das absolute Maximum aufweisen, quantisierte Löcher- bzw. Elektronenzustände aufweisen, derart weitergebildet, daß zwischen den beiden inneren Schichten mit dem Valenzbandoberkantenmaximum und dem Leitungsbandunterkantenminimum, zu denen lokalisierte Elektronen- bzw. Löcherzustände existieren, deren Eigenfunktionen überlappen, eine weitere Schicht angeordnet ist, die zur Kompensation der sich innerhalb der Schichten ausbildenden Kristallverspannungen dient und einen graduellen Bandkantenübergang zwischen den inneren Schichten bildet, so daß die Schichtdicke der inneren Schichten erhöht werden kann und sich somit die zugehörige Emissions- bzw. Absorptionswellenlänge ebenfalls erhöht.

Mit Hilfe einer erfindungsgemäßen Zwischenschicht sind auf Galliumarsenidsubstraten insbesondere Quantenschichtstrukturen herstellbar, deren Emissions- bzw. Absorptionswellenlängen bei 1,3 µm und/oder 1,55 µm liegen, während bei InP-Substraten Wellenlängen zwischen 2 und 5 µm möglich sind.

Aus diesen Quantenschichtstrukturen lassen sich dann Laser, wie z.B. Halbleiterinjektionslaser, Modulatoren, Detektoren und Heterobipolartransistoren herstellen. Mit den erfindungsgemäßen Quantenschichtstrukturen ist es vorteilsweise möglich, die optoelektronischen Bauelemente mit komplexen elektronischen Schaltungen auf Galliumarsenid- bzw. Indiumphosphidsubstraten monolitisch zu integrieren.

Ein wesentlicher Vorteil der Erfindung ist der vergleichsweise geringere Preis bei Verwendung von Galliumarsenidsubstraten im Vergleich zu z.B. Indiumphosphitsubstraten und bei Verwendung von Indiumphosphitsubstraten werden die Nachteile, die insbesondere bei der Verwendung von Bleisalzlaserdioden auftreten, nämlich die notwendige Kühlung, das instabile Modenspektrum und die unbefriedigende Zuverlässigkeit vermieden. Diese Vorteile kommen schon bei der Fabrikation von Einzelbauelementen zum tragen.

Das absolute Minimum und das absolute Maximum ist in den beiden genannten inneren Schichten vorhanden, auch wenn keine weiteren Dotierstoffe in die Schichten oder Grenzschichten eingebaut sind. Ferner ist es natürlich auch möglich die verwendeten Schichten zu dotieren oder eine Spannung anzulegen, ohne daß die genannten Extremwerte verschwinden.

Die Schichten, die die Extremwerte aufweisen, sind sehr dünn, so daß lokalisierte Elektronen- bzw. Löcherzustände existieren. Auf diese Weise überlappen deren Eigenfunktionen, daß eine strahlende Rekombination von Elektronen und Löchern aus den jeweiligen Schichten ermöglicht wird. Ein typischer Abstandswert zwischen den Schichten, bis zu dem eine strahlende Rekombination stattfindet liegt bei 1nm.

Für einen effizienten Laser mit wenig oder nur einer Mode ist es notwendig, daß der Rekombinationsprozeß zwischen den Löchern und Elektronen, deren Eigenfunktionen überlappen, der dominante strahlende Rekombinationsprozeß in der Schichtstruktur ist.

Zur Erhöhung der Wellenlänge des emittierten oder absorbierten Lichts ist es erfindungsgemäß erkannt worden, zwischen den beiden inneren Schichten, die das Valenzbandoberkantenmaximum und das Leitungsbandunterkantenminimum aufweisen, eine weitere Schicht einzubringen ist. Diese weitere Schicht dient zur Spannungskompensation und einem graduellen Übergang zwischen den umliegenden Schichten.

Zur Verwendung von Quantenschichtstrukturen in technisch relevanten Bauteilen, bei denen typischerweise GaAs- oder InP-Substrate verwendet werden, sollte zumindest eine Schicht mindestens teilweise pseudomorph oder gitterangepaßt sein. Bevorzugterweise werden mehrere Schichten gitterangepaßt, um die Quantenausbeute zu erhöhen und die Degradation zu verringern. Allerdings können auch Versetzungen gewünscht sein, wie das Beispiel der blauen Leuchtdiode auf Galliumnitridbasis zeigt, bei der bei einer Versetzungsdichte von ca. 10¹⁰/cm² eine sehr hohe Quantenausbeute erzielt wird.

Sofern die aufeinanderfolgenden Schichten der Quantenschichtstruktur zu unterschiedliche Gitterkonstanten aufweisen, so ist es insbesondere bei Verwendung von dickeren Schichten erfoderlich, zwischen aufeinanderfolgenden Schichten spannungskompensierende Schichten einzubringen. Zur Gitteranpassung und Spannungskompensation haben sich phosphorhaltige Schichten, insbesondere GaAsₓP₁₋ₓ mit x zwischen 0 und 1 als vorteilhaft erwiesen. Es ist natürlich auch möglich spannungskompensierende Schichten aus tertiären oder quartenären Verbindungen aus Gallium, Indium, Arsen und Phosphor zu verwenden.

Um bessere Wachstumsbedindungen oder bestimmte anisotrope physikalische Eigenschaften der Quantenschichtstrukturen zu erreichen, können diese unter Zugspannung hergestellt werden.

Das Material der Schichten der Quantenschichtstruktur ist natürlich nicht auf III-V-Verbindungen beschränkt. Sie können mindestens zwei verschiedenen II-VI-Verbindungen und/oder IV-VI-Verbindungen und/oder III-V-Verbindungen und/oder Gruppe IV-Verbindungen aufweisen.

Die verwendeten Halbleiterschichten können Verbindungen aus mindestens zwei oder drei der folgenden Elemente Al, Ga, In, P, As und Sb aufweisen. Damit wird eine für die jeweiligen Anwendungsfälle optimale Anpassung der Bandlücken und relativen Positionen der Valenzbandoberkante und der Leitungsbandunterkante erreicht. Die Option der Dotierung der verwendeten Halbleiter ermöglicht zum einen eine Art "Bandstruktur-Engineering" und zum anderen die Einstellung der gewünschten Leitfähigkeit der verwendeten Materialien.

Sofern die Quantenschichtstruktur in einen Laser eingesetzt werden soll, empfiehlt es sich, wenn mindestens eine Quantenschicht in eine Wellenleiterstruktur aus II-IV-, III-V-, IV-VI- oder Gruppe IV-Halbleitermaterial oder Kombinationen dieser Halbleitermaterialien eingebettet ist bzw. sind.

Vorzugsweise werden die Schichtfolgen der Quantenwellstruktur derart gewählt, daß sowohl Typ-I-Heteroübergänge als auch Typ-II-Heteroübergänge möglich sind.

Bei einer Schichtfolge, die einen Typ-II Heteroübergang darstellt, ist es sinnvoll, die Injektionsrichtung von Elektronen und Defektelektronen bzw. Löchern mit der Barrierenlage abzustimmen. Dieses ist z.B. bei Halbleiterlasern sinnvoll, da so der Schwellenstrom minimiert wird. Es ist allerdings auch möglich, daß die verwendeten Materialien eine derart geringe Barriere bei einem Typ-II-Heteroübergang bilden, daß es für die Funktionsweise eines Bauelements unbeachtlich ist, welche Injektionsrichtung die Elektronen bzw. Defektelektronen haben.

Sollte bei einem Typ-II-Heteroübergang die Barriere recht groß sein, so gibt es eine weitere Möglichkeit, die möglicherweise entstandene Barriere zu umgehen. Dazu wird der Wellenleiter unsymmetrisch ausgeführt.

Es ist außerdem möglich, die Barriere in der Höhe abzubauen, in dem bei Verwendung von Galliumarsenidsubstraten z.B. Aluminium zugeführt wird. Mit Erhöhung des Aluminiumgehaltes in Al_{y}Ga_{1-y}As wird die Höhe der Barriere verringert. Allerdings hat sich auch herausgestellt, daß sich die optische Qualität des Wellenleiters durch Erhöhung des Aluminiumgehaltes verringert. Deswegen erscheint ein Aluminiumgehalt von ungefährt 10% am geeignetsten.

### Kurze Beschreibung der Zeichnung

Die Erfindung sowie der Stand der Technik wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:
- Fig. 1: Banddiagramm eines konventionellen AlGaAs/GaAs-Quantenbrunnenlasers mit InGaAs-Quantenbrunnen.
- Fig. 2: Vergrößerter Ausschnitt (S1; S2,S3; S4) aus Fig. 1 mit vereinfachtem Energietermschema (E', E''), höhere Energiezustände sind nicht gezeigt, Existenz von leichten und schweren Defektelektronen ist nicht berücksichtigt.
- Fig. 3: Lage der Leitungs- und Valenzbandkanten (dick gezeichnete Kurven) und der niedrigsten Elektronen- und Defektelektronenenergie (dünn gezeichnete Kurven) in pseudomorphen, kritisch dicken GaₓIn₁₋ₓAs-Quantenbrunnen als Funktion des Kompositionsfaktors "x", die Pfeile 1 und 2 zeigen den Bandabstand und Rekombinationsenergie im Quantenbrunnen für einen Brunnen mit 35% In-Gehalt, Fixpunkte für x=1 sind Bandkantenenergien der rechts und links vom Brunnen liegenden GaAs-Schichten.
- Fig. 4: a) Halbleiterschichtfolge einer bekannten Quantenschichtstruktur mit Schichten S1, S2, S3 und S4, mit den Schichtdicken d1, d2, d3, d4 und den Energielücken E1, E2, E3 und E4.
b) Das zu a) gehörende vereinfachte Banddiagramm.
c) Betrag der Eigenfunktionen der Löcher (Φₕ) und Elektronen (Φₑ).
- Fig. 5: Quantenschichtstruktur, bei der im Verhältnis zu Figur 4 zwischen den Schichten S2 und S3 eine Schicht S10 eingefügt worden ist, die eine graduellen Übergang von GaAsSb zu GaInAs ermöglicht.
- Fig. 6: Quantenschichtstruktur entsprechend Figur 5 bei der anstelle des graduellen Übergangs eine GaInP-Schicht z.B. zur Spannungskompensation verwendet wird.

### Darstellung von Ausführungsbeispielen

In den folgenden Figuren sind jeweils gleiche oder entsprechende Teile mit den selben Bezugszeichen bezeichnet, so daß auf eine erneute Vorstellung verzichtet wird, und lediglich die Abweichungen der in diesen Figuren dargestellten Ausführungsbeispiele gegenüber dem ersten Ausführungsbeispiel erläutert werden:

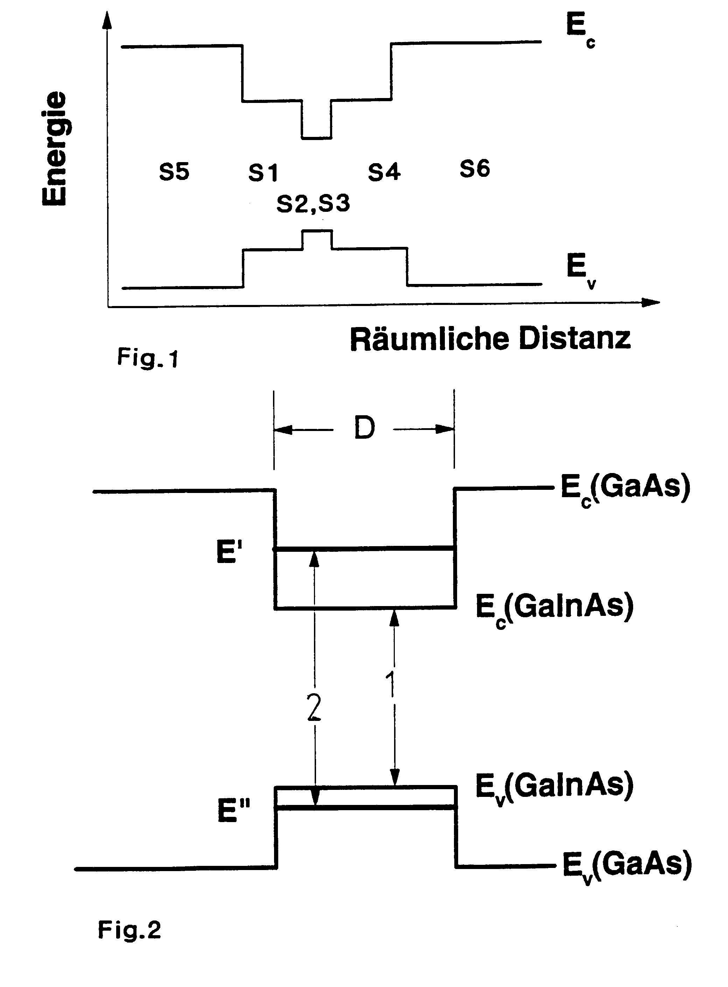

Fig. 1 zeigt ein Banddiagramm eines konventionellen AlGaAs/GaAs-Quantenbrunnenlasers mit InGaAs-Quantenbrunnen. Dabei ist das vereinfachte (feldfreier Fall) Banddiagramm gezeigt. S5 und S6 sind die optischen Confinement-Schichten aus AlGaAs, die Schichten S1 und S4 aus GaAs formen zusammen mit der eingeschlossenen aktiven Schicht S2 bzw. S3 aus GaInAs den optischen Wellenleiter.

Das Banddiagramm dieser Quantenschichtstruktur zeigt eine "direkte" Bandlücke. Da hier nicht im herkömmlichen Sinn von direkt gesprochen werden kann, da es sich bei der Darstellung in Fig. 1 nicht um einen Impulsraum handelt sondern um einen Ortsraum, ist direkt in Anführungszeichen gesetzt.

Bevor näher auf die Figuren eingegangen wird, sollen einige verwendete Begriffe erläutert werden:

Die Bandlücke E_{g} ist die Energiedifferenz zwischen der Leitungsbandunterkante CBM bzw. E_{c} und der Valenzbandoberkante VBM bzw. Eᵥ. Als "direkte" Bandlücke wird die Bandlücke verstanden, bei der räumlich die Leitungsbandunterkante in den Figuren direkt über der Valenzbandoberkante liegt. Als "indirekte" Bandlücke wird die Bandlücke verstanden, bei der in den Figuren CBM nicht direkt über VBM liegt.

In Fig. 1 wird als Substrat (S5, S6) z.B. GaAs benutzt. Die Quantenschicht bzw. der Quantenbrunnen (S2, S3) kann z.B. Galliumarsenidantimonid oder Galliumindiumarsenid sein. Zur Vereinfachung wurde eine Darstellungsweise gewählt, bei der keine Bandverbiegung herrscht. Da dieser Fall in der Praxis kaum vorkommt, sind die Figuren nur als Beispiele anzusehen, die sich nicht auf das Flachbandverhalten beschränken.

Die fundamentale Bandlücke von GaAs beträgt bei 0 K 1,519 eV. Die fundamentale Bandlücke von Galliumarsenidantimonid bzw. Galliumindiumarsenid ist kleiner als die von GaAs. GaAs-Schichten können also als Barrierenschichten für Elektronen bzw. Löcher fungieren, wenn das Material der in GaAs eingeschlossenen Quantenschicht z.B GaAsSb oder GaInAs, also ein Material mit einer kleineren Bandlücke ist.

Durch geschicktes Aufbringen des Materials der Quantenschicht(en) auf GaAs durch z.B. Molekularstrahlepitaxie (MBE) ist es möglich, die Quantenschicht(en) epitaktisch aufzuwachsen. Aufgrund der verschiedenen Gitterkonstanten entstehen bei diesem Prozeß relativ hohe Druckspannungen in der aufgewachsenen Quantenschichtschicht. Ab einer gewissen Schichtdicke würden Bindungen in der Quantenschichtschicht aufbrechen und es entstünde eine polykristalline Schicht (siehe z.B. J.W. Matthews und A.E. Belakeslee, J. Cryst, Growth, 27, 1974, 118). Um diesen Effekt zu verhindern, ist es möglich, die Quantenschichtstruktur unter Zugspannung aufwachsen zu lassen. Allein durch diese Maßnahme können theoretisch Quantenschichtstrukturen mit einer Emissions- bzw. Absorptionswellenlänge von 1,3 µm bzw. 1,55 µm erreicht werden.

In Fig. 2 ist ein vergrößerter Ausschnitt aus Fig. 1 mit vereinfachtem Energietermschema (E', E'') dargestellt. Die Schichten S1, S2 bzw. S3 und S4 sind zu erkennen. Höhere Energiezustände als die dargestellten sind nicht gezeigt.

Pfeil 1 markiert den Bandabstand im Quantenbrunnen. Dieser Bandabstand ist nur vom Indium-Gehalt der GaInAs-Quantenschicht abhängig. Ist die Dicke D dieser Schicht größer als einige 10nm, dann wird die Emissionswellenlänge des Lasers ziemlich genau mit diesem Bandabstand (1eV =1,24µm) korrespondieren. Liegt die Dicke deutlich unter 10nm, dann verkürzt sich die Emissionswellenlänge mit abnehmender Dicke D. Ursache ist der mit abnehmender Dicke D immer stärker in Erscheinung tretende sogenannte Quantisierungseffekt (quantum size effect). Die niedrigste Elektronenenergie im Quantenbrunnen ist jetzt nicht mehr die Bandkantenenergie E_{c} (GaInAs) sondern die etwas höhere Energie E'.

Für die Defektelektronen im Valenzband des Quantenbrunnens ist der Effekt wegen der größeren Masse der Defektelektronen schwächer. Ihre niedrigste Energie E'' ist darum nur wenig größer als Eᵥ (GaInAs). Der für die Emissionswellenlänge des Lasers maßgebende Übergang findet zwischen E' und E'' statt (Pfeil 2). Nur für dicke Quantenbrunnen und damit vernachlässigbarem Quantisierungseffekt fallen die Energien E' und E'' mit den Bandkantenenergien Ec (GaInAs) und Ev(GaInAs) zusammen. Die tatsächlichen Verhältnisse im Valenzband (leichte u. schwere Defektelektronen etc.) sind etwas komplizierter als hier dargestellt, für die hier zu diskutierenden Dinge kann man diese Feinheiten aber übergehen. Insgesamt führt der Quantisierungseffekt dazu, daß die Emissionswellenlänge mit abnehmender Dicke D und damit wachsendem Abstand E'-E'' immer weiter abnimmt.

Strebt man eine möglichst große Emissionswellenlänge an, dann wird man also, erstens den Quantisierungseffekt durch Wahl einer großen Dicke D ausschalten und zweitens für den Quantenbrunnen ein GaₓIn₁₋ₓAs mit hohem In-Gehalt (kleiner "x"-Wert) und damit entsprechend kleinem Bandabstand (kleine Differenz E_{c} (GaInAs)-Eᵥ (GaInAs)) auswählen.

GaₓIn₁₋ₓAs und GaAs haben kubische Gitterstruktur, aber für x<1 nicht die gleiche Gitterkonstante. Die Gitterkonstante von GaₓIn₁₋ₓAs wächst mit abnehmendem "x"-Wert linear von 0,56 nm (Ga₁In₀As=GaAs) auf 0,66nm (Ga₀In₁As=InAs) an. Versucht man GaInAs auf GaAs epitaktisch aufzuwachsen, so stellt man fest, daß dieses nur bis zu einer gewissen Dicke für ein gewisses Ga-In-Gemisches der GaInAs-Schichten möglich ist.

Deponiert man z.B. in einer Epitaxieanlage auf GaAs-Substraten z.B. Ga_{0.8}In_{0.2}As-Schichten (x=0.8 bzw. 20% Indium-Gehalt) z.B. 1,10 und 100nm Dicke, dann findet man, daß die 1 und 10nm dicken Schichten eine perfekte Kristallqualität aufweisen. Röntgentechnische Analysemethoden zeigen, daß das GaInAs in Ebenen parallel zur Substratebene genau die Periodizität des GaAs-Kristalles übernommen hat, aber nicht mehr perfekt kubisch ist. Senkrecht zur Substratoberfläche sind die Elementarzellen des GaInAs-Gitters etwas gestreckt. Die Elementarzelle ist nicht mehr kubisch, sondern tetragonal. GaAs-Substrat (kubisch) und GaInAs-Schicht (tetragonal) sind nicht mehr isomorph aber kristallographisch auch nicht total verschieden voneinander. In bestimmten Ebenen haben sie gleiche Periodizität, man sagt darum, sie seien pseudomorph. Die tetragonale Verzerrung entsteht durch biaxiale mechanische Deformation der unverzerrten kubischen Elementarzelle des GaInAs.

In den pseudomorphen Schichten sind darum erhebliche, mit wachsender Schichtdicke ebenfalls wachsende Deformationsenergien gespeichert und das führt dazu, daß bei Überschreiten einer sogenannten kritischen Schichtdicke das wohlgeordnete Wachstum zusammenbricht. Das GaInAs erträgt die ihm vom Substrat aufgezwungene Gitterstruktur nicht mehr und wandelt sich unter Bildung sogenannter Fehlanpassungsversetzungen (misfit dislocations) in seine natürliche kubische Gestalt um. Die optischen und elektrischen Eigenschaften dieser von Versetzungen durchsetzten Schichten sind schlecht. Gute Laser sind aus diesem Material nicht mehr herstellbar.

Die kritische Schichtdicke, bei der die pseudomorphe Struktur zusammenbricht, hängt nur vom In-Gehalt ab (siehe J. W. Matthew und A. E. Blakeslee, J. Cryst. Growth, 27 (1974), 118 - 125) und alle in den letzten 10 Jahren unternommenen Versuche, durch züchtungstechnische Tricks den Kollaps zu unterdrücken, sind gescheitert. Matthew und Blakeslee haben vor 20 Jahren dazu quantitativ einen Zusammenhang zwischen kritischer Schichtdicke und Gitterfehlpassung formuliert.

Die aus dieser Regel resultierenden Konsequenzen für die Konstruktion von Laserstrukturen sind sehr einschneidend. Steigert man den In-Gehalt im Quantenbrunnen, was zu längeren Emissionswellenlängen führt, dann muß man gleichzeitig die Schichtdicke des Quantenbrunnens wegen abnehmender kritischer Schichtdicke immer weiter zurücknehmen. Mit abnehmender Schichtdicke schießen aber die Energiezustände E' und E'' in die Höhe, was in die falsche Richtung geht und zu kürzeren Emissionswellenlängen schiebt. Insgesamt stellt sich heraus, daß mit wachsendem In-Gehalt und Ausreizen der Schichtdicke bei ca. 35% In-Gehalt eine maximale Emissionswellenlänge von 1,1µm erreicht wird. Größere In-Gehalte führen wegen der rapide abnehmenden kritischen Schichtdicke zu einem überhandnehmendem Quantisierungseffekt. Die Emissionswellenlängen nehmen dann wieder ab.

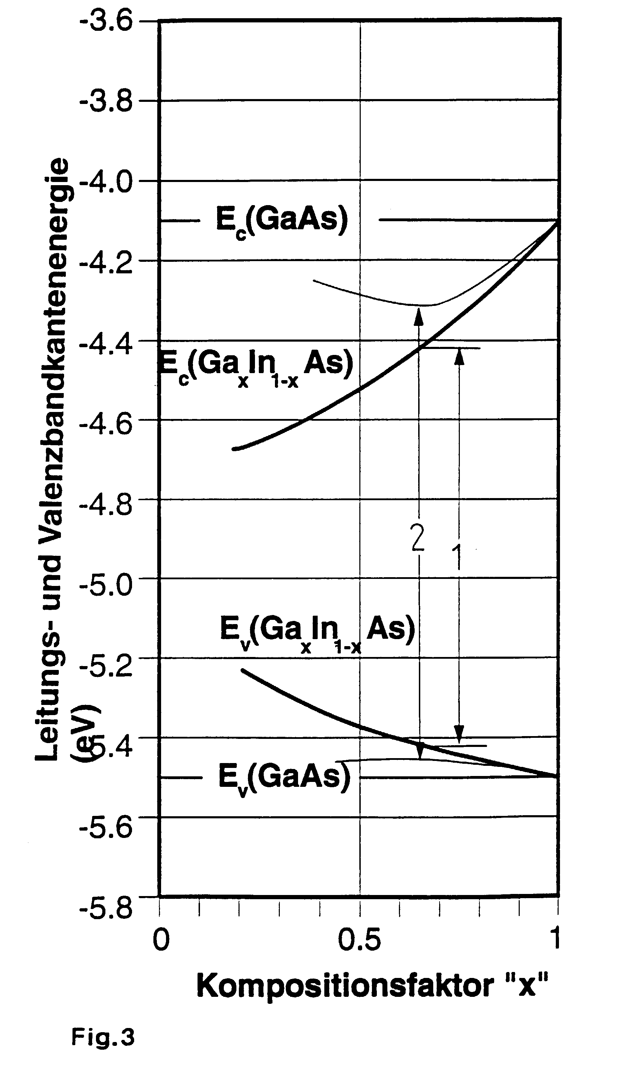

In Fig. 3 sind diese Zusammenhänge graphisch dargestellt. Die dick ausgezogenen Linien zeigen den Verlauf der Bandkantenenergien und die dünnen Linien zeigen die Energien E' und E'' für Quantenbrunnen mit maximaler, also kritischer Schichtdicke.

Die erfindungsgemäße Lösung dieses Problems ist es, spannungskompensierenden Schichten in die Quantenschichtstrukturen einzubauen. Damit werden die beim Aufwachsen von Schichten entstehenden Spannungen verringert und es ist möglich dickere Schichten epitaktisch aufwachsen zu lassen. Derartige spannungskompensierende Schichten, die aus den verschiedensten Materialien bestehen können, lassen sich je nach Anwendungsfall an unterschiedlichen Stellen in der Schichtstruktur einbringen.

Wenn die verwendeten Materialien nicht dotiert worden sind, liegt die Fermi-Energie in der Mitte der Bandlücke. Es ist natürlich auch möglich, daß für die jeweils verschiedenen Materialien auch unterschiedliche Dotierungen benutzt werden und sich dadurch die relativen Lagen der Valenzbandoberkante bzw. der Leitungsbandunterkante relativ zueinander verschieben.

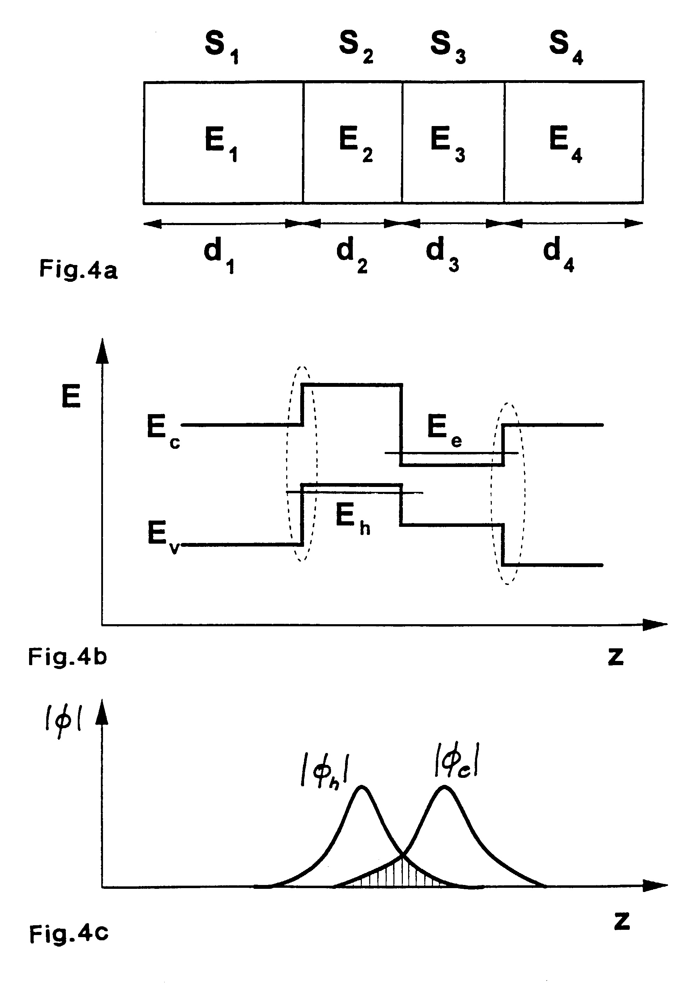

Ausgehend von einer an sich bekannten Quantenschichtstruktur, die in den Figuren 4a bis 4c dargestellt sind soll anschließend eine erfindungsgemäße Schichtstruktur mit Spannungskompensationsschicht beschrieben werden.

Die bekannte Quantenschichtstruktur gemäß Fig. 4a kann auf einem Substrat aus Galliumarsenid oder Indiumphosphit epitaktisch abgeschieden sein. Das Substrat bestimmt dabei den Spektralbereich für den die Quantenschichtstruktur geeignet ist.

Die Quantenschichtstruktur besteht aus vier Halbleiterschichten S1, S2, S3 und S4 mit den Dicken d1, d2, d3 und d4. Die Schichten S1 und S4 haben die Bandabstände E1 und E4. Diese Schichten werden im folgenden Barrierenschichten genannt. Zwischen den Barrierenschichten (S1, S4) sind Halbleiterschichten S2 und S3 mit den Bandabständen E2 und E3 eingebettet.

Fig. 4b zeigt beispielsweise für eine Schichtfolge S1-S2-S3-S4 den Verlauf der Leitungs- und Valenzbandkantenenergien E_{c} und Eᵥ über eine senkrecht auf der Schichtfolge stehenden Ortskoordinate z. S1 kann dabei aus GaAs, S2 aus GaAsₓSb₁₋ₓ, S3 aus Ga_{y}In_{1-y}As und S4 aus Ga_{0,5}In_{0,5}P oder Al_{0,2}Ga_{0,8} As. Bei einer derartigen Materialkombination ist der links gestrichelt eingekreiste Heteroübergang von der Schicht S1 zur Schicht S2 ein Typ-II-Heteroübergang und der rechts eingekreiste Übergang von S3 zu S4 vom Typ-I.

Bei den verwendeten Materialien ist der Bandabstand E4 der Schicht S4 etwas größer als der der Schicht S1. Sofern als Schicht S4 Galliumarsenid verwendet wird, wären die Bandlücken E4 und E1 gleich groß.

Wesentlich für die Quantenstruktur ist die Wahl der Materialien für die Schichten S2 und S3 und der aus dieser Wahl resultierende Verlauf der Bandkanten im Zentralbereich der Quantenschichtstruktur.

Die Schicht S3 weist im Bereich des Schichtstapels ein absolutes Minimum der Leitungsbandunterkante auf und die Schicht S2 weist ebenfalls im Bereich des Schichtstapels ein absolutes Maximum der Valenzbandoberkante auf. Die quantisierten Elektronen und Lochzustände, deren Energie am nächsten zu VBM bzw. CBM sind, sind durch Eₑ und Eₕ in der Fig. 4b dargestellt.

Wesentlich für die Funktionsweise eines derartig aufgebauten Lasers ist, daß der Betrag der Eigenfunktionen dieser lokalisierten Elektronen und Löcherzustände derart überlappt, daß eine strahlende Rekombination dieser Elektronen mit diesen Löchern möglich ist. Siehe dazu Figur 4c. Dieser Überlapp existiert auch schon ohne Anlegen einer äußeren Spannung. Der Vorteil dabei ist, daß ein großer Überlapp der Eigenfunktionen der Elektronen- und Löcherzustände auch ohne angelegte Spannungen, die zu einer Bandverbiegung führen, wodurch bei weniger effektiven Bauelementen es erst zu einer Quantisierung von Elektronen und Lochzuständen stattfindet, auch schon bei sehr geringer Strominjektion z.B. ein Laser der aus einer derartigen Schichtfolge hergestellt worden ist mit hohem Wirkungsgrad anfängt zu lasern. Der wesentliche Vorteil einer derartigen Quantenschichtstruktur, nämlich der kleine Schwellstrom, kommt nur dann zustande, wenn schon unterhalb der Laserschwelle Elektronen und Löcher in Quantentrögen eingesperrt sind.

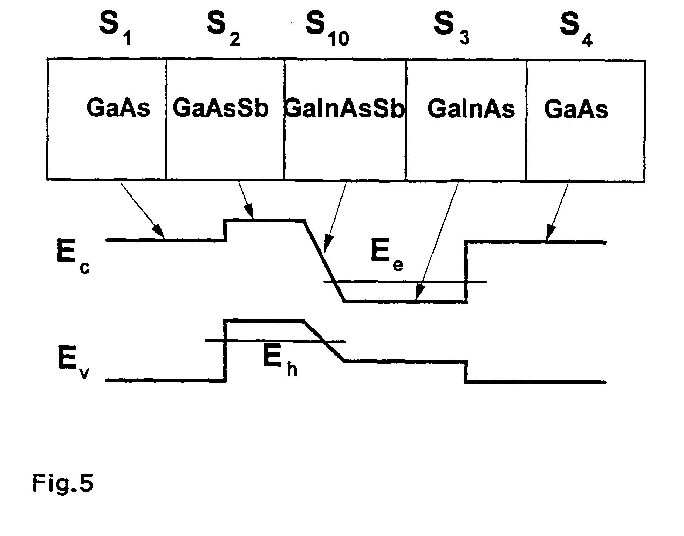

In Fig. 5 ist die erfindungsgemäße Modifikation der in Fig. 4 gezeigten Quantenschichtstruktur dargestellt. Zwischen den Schichten S2 und S3 ist eine erfindungsgemäße Schicht S10 eingebaut, die eine quaternäre Schicht wie z.B. GaₓIn₁₋ₓAs_{y}Sb_{1-y} sein kann, die mit stetig variierenden x und y stetig von der chemischen Komposition der Schicht S2 zur chemischen Komposition der Schicht S3 überleitet. Bei der Schichtstrukturherstellung wird häufig ein derartiger gradueller Übergang ungewollt entstehen, da bisher nur bei wenigen Schichten abrupte d.h. atomare Übergänge möglich sind. Wenn diese Zwischenschicht S10 allerdings dünn ist, d.h. bis ca. 1 nm, so daß die Eigenfunktionen der Elektronen und Löcher immer noch überlappen können, stört diese Zwischenschicht nur unwesentlich die Funktion der vorstehend beschriebenen Quantenschichtstruktur.

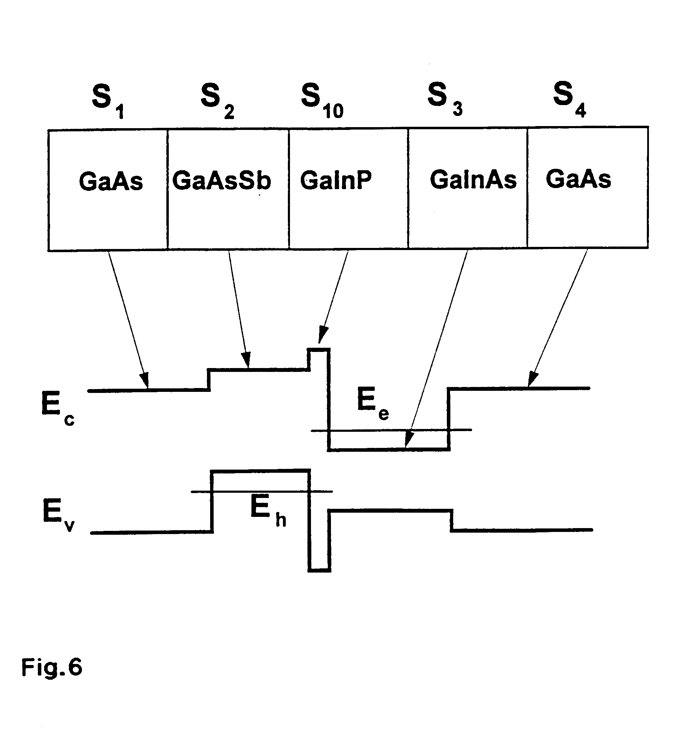

In Fig. 6 ist als Zwischenschicht eine GaInP-Schicht gezielt eingebaut worden, die etwaige elastische Verspannungen zwischen den Schichten S2 und S3 kompensieren kann. Wie Photolumineszenzdaten an einer Quantenschichtstruktur belegen, findet bei Schichten von ca. 1 nm zwischen Eₑ und Eₕ immer noch eine strahlende Rekombination statt.

Spannungskompensierende Schichten können natürlich auch z.B. zwischen den Schichten S1 und S2 sowie zwischen den Schichten S3 und S4 eingebracht werden.

Vorzugsweise werden Halbleitermaterialien in Quantenwellstrukturen eingesetzt, die chemisch so zusammengesetzt sind, daß eine Teilmenge dieser Halbleiterschichten biaxial gestreckt und eine andere Teilmenge biaxial gestaucht ist. Diese Halbleitermaterialien werden entweder vollständig oder bereichsweise pseudomorph in der Quantenschichtstruktur eingesetzt. Dabei ist es selbstverständlich möglich, daß in der Quantenschicht einschließenden Wellenleiterstruktur Schichten eingebaut sind, die biaxial gestreckt oder gestaucht sind.

Eine Kompensation der mechanischen Spannungen mit spannungskompensierenden Schichten ist insbesondere dann notwendig, wenn mehrere mechanisch verspannte Quantenschichtstrukturen zu einer aktiven Schicht vereinigt werden sollen. Um dies zu ermöglichen, wird in die Barrierenstruktur zur Spannungskompensation z.B. Phosphor eingebaut. D.h., daß als spannungskompensierende Schichten z.B. Galliumarsenidphosphit-Schichten eingesetzt werden können. Weiterhin sind als spannungskompensierende Schichten auch quaternäre Verbindungen aus den Materialien Gallium, Indium, Arsen, Antimon und Phosphor denkbar.

Die mehrschichtigen Quantenschichtstrukturen können durch Verwendung von Zugspannungen zur Kompensation der Druckspannungen, die durch die verschiedenen Gitterparameter der verschiedenen Schichten entstehen, hergestellt werden. Typischerweise werden Herstellverfahren wie z.B. die Molekularstrahlepitaxie (MBE), die Chemical Vapor Deposition (CVD), die Metal Organic Chemical Vapor Deposition (MOCVD) und die Low Pressure Chemical Vapor Deposition (LPCVD) und andere verwendet.

## Patentansprüche

1. Quantenschichtstruktur für Laser oder Detektoren, mit mindestens vier Halbleiterschichten (S1, S2, S3, S4), wobei
- zwischen zwei äußeren Barrierenschichten (S1, S4) mindestens zwei innere Schichten (S2, S3) angeordnet sind,
- ohne Anlegen einer elektrischen Spannung die Leitungsbandunterkante einer der inneren Schichten ein absolutes Minimum in der Leitungsbandunterkante hinsichtlich aller Schichten in der Quantenstruktur und die Valenzbandoberkante einer weiteren inneren Schicht ein absolutes Maximum in der Valenzbandoberkante hinsichtlich aller Schichten in der Quantenstruktur aufweist, und
- zumindest die beiden inneren Schichten, die das absolute Minimum und das absolute Maximum aufweisen, quantisierte Löcher- bzw. Elektronenzustände aufweisen,
dadurch **gekennzeichnet**, daß zwischen den beiden inneren Schichten (S2, S3) mit dem Valenzbandoberkantenmaximum und dem Leitungsbandunterkantenminimum, zu denen lokalisierte Elektronen- bzw. Löcherzustände existieren, deren Eigenfunktionen überlappen, eine weitere Schicht (S10) angeordnet ist, die zur Kompensation der sich innerhalb der Schichten ausbildenden Kristallverspannungen dient und einen graduellen Bandkantenübergang zwischen den inneren Schichten (S2, S3) bildet, so daß die Schichtdicke der inneren Schichten (S2, S3) erhöht werden kann und sich somit die zugehörige Emissions- bzw. Absorptionswellenlänge ebenfalls erhöht.

2. Quantenschichtstruktur nach Anspruch 1,
dadurch **gekennzeichnet**, daß die Eigenfunktionen der lokalisierten Elektronen- bzw. Löcherzustände so weit überlappen, daß eine strahlende Rekombination von Elektronen und Löchern aus den jeweiligen Schichten ermöglicht wird.

3. Quantenschichtstruktur nach Anspruch 2,
dadurch **gekennzeichnet**, daß der Rekombinationsprozeß der dominante strahlende Rekombinationsprozeß in der Schichtstruktur ist.

4. Quantenschichtstruktur nach einem der Ansprüche 1 bis 3,
dadurch **gekennzeichnet**, daß zumindest eine Halbleiterschicht mindestens teilweise pseudomorph oder gitterangepaßt ist.

5. Quantenschichtstruktur nach einem der Ansprüche 1 bis 4,
dadurch **gekennzeichnet**, daß die Halbleiterschichten der Quantenschichtstruktur mindestens zwei verschiedenen II-VI-Verbindungen und/oder IV-VI-Verbindungen und/oder III-V-Verbindungen und/oder Gruppe IV-Verbindungen aufweisen.

6. Quantenschichtstruktur nach einem der Ansprüche 1 bis 5,
dadurch **gekennzeichnet**, daß Halbleiterschichten aus III-V-Verbindungen gebildet ist.

7. Quantenschichtstruktur nach einem der Ansprüche 1 bis 6,
dadurch **gekennzeichnet**, daß die Halbleiterschichten auf einem Substrat aufgebracht sind, für das GaAs oder InP verwendet wird.

8. Quantenschichtstruktur nach einem der Ansprüche 1 bis 7,
dadurch **gekennzeichnet**, daß die Halbleiterschichten Verbindungen aus mindestens zwei der folgenden Elemente Al, Ga, In, P, As und Sb aufweisen.

9. Quantenschichtstruktur nach einem der Ansprüche 1 bis 8,
dadurch **gekennzeichnet**, daß die Halbleiterschichten mindestens drei der folgenden Elemente Al, Ga, In, P, As und Sb aufweisen.

10. Quantenschichtstruktur nach einem der Ansprüche 1 bis 9,
dadurch **gekennzeichnet**, daß die Halbleiterschichten dotiert sind.

11. Quantenschichtstruktur nach einem der Ansprüche 1 bis 10,
dadurch **gekennnzeichnet**, daß mindestens eine Quantenschicht in eine Wellenleiterstruktur aus II-IV-, III-V-, IV-VI- oder Gruppe IV-Halbleitermaterial oder Kombinationen dieser Halbleitermaterialien eingebettet ist bzw. sind.

12. Quantenschichtstruktur nach einem der Ansprüche 1 bis 11,
dadurch **gekennzeichnet**, daß in vollständig oder bereichsweise pseudomorphen Quantenschichtstrukturen Halbleitermaterialien verwendet werden, die chemisch so zusammengesetzt sind, daß eine Teilmenge dieser Halbleiterschichten biaxial gestreckt und eine andere Teilmenge biaxial gestaucht ist.

13. Quantenschichtstruktur nach einem der Ansprüche 1 bis 12,
dadurch **gekennzeichnet**, daß zwischen den Halbleiterschichten mindestens eine spannungskompensierende Schicht eingebracht ist.

14. Quantenschichtstruktur nach einem der Ansprüche 1 bis 13,
dadurch **gekennzeichnet**, daß eine Wellenleiterstruktur Quantenschichten oder die Quantenschichtstruktur einschließt.

## Claims

1. A quantum-layer structure for lasers or detectors, with at least four semiconductor layers (S1, S2, S3, S4), wherein
- at least two inner layers (S2, S3) are disposed between two outer bamer layers (S1, S4),
- without the application of an electrical voltage, the conduction band lower edge of one of the inner layers has an absolute minimum in the conduction band lower edge relative to all layers in the quantum structure and the valence band upper edge of a further inner layer has an absolute minimum in the valence band upper edge relative to all layers in the quantum structure, and
- at least the two inner layers which have the absolute minimum and the absolute maximum have quantized hole or electron states,
characterized in that a further layer (S10) is arranged between the two inner layers (S2, S3) with the valence band upper edge maximum and the conduction band lower edge minimum, at which localised electron or hole states exist whose eigenfunctions overlap, the further layer serving to compensate for the crystal stresses occurring within the layers and forming a gradual band edge transition between the inner layers (S2, S3), so that the layer thickness of the inner layers (S2, S3) can be increased and the corresponding emission or absorption wavelength thus be likewise increased.

2. A quantum-layer structure according to claim 1, characterized in that the eigenfunctions of the localised electron or hole states overlap sufficiently for radiating recombination of electrons and holes from the respective layers is facilitated.

3. A quantum-layer structure according to claim 2, characterized in that the recombination process is the dominant radiating recombination process in the layer structure.

4. A quantum-layer structure according to any of claims 1 to 3, characterized in that at least one semiconductor layer is at least partially pseudomorphic or lattice-matched.

5. A quantum-layer structure according to any of claims 1 to 4, characterized in that the semiconductor layers of the quantum layer structure compose at least two different II-IV compounds and/or IV-VI compounds and/or III-V compounds and/or group IV compounds.

6. A quantum-layer structure according to any of claims 1 to 5, charactenzed in that semiconductor layers is formed from III-V compounds.

7. A quantum-layer structure according to any of claims 1 to 6, characterized in that the semiconductor layers are applied on a substrate, for which GaAs or InP is used.

8. A quantum-layer structure according to any of claims 1 to 7, characterized in that semiconductor layers comprise compounds of at least two of the following elements: Al, Ga, In, P, As and Sb.

9. A quantum-layer structure according to any of claims 1 to 8, characterized in that the semiconductor layers comprise at least three of the following elements: Al, Ga, In, P, As and Sb.

10. A quantum-layer structure according to any of claims 1 to 9, characterized in that the semiconductor layers are doped.

11. A quantum-layer structure according to any of claims 1 to 10, characterized in that at least one quantum layer is embedded in a waveguide structure of II-IV, III-V, IV-VI or group IV semiconductor material or combinations of these semiconductor materials.

12. A quantum-layer structure according to any of claims 1 to 11, characterized in that semiconductor materials are used in completely or partially pseudomorphic quantum layer structures and are chemically so composed that a portion of these semiconductor layers is biaxially stretched and another portion is biaxially compressed.

13. A quantum-layer structure according to any of claims 1 to 12, characterized in that at least one voltage compensating layer is disposed between the semiconductor layers.

14. A quantum-layer structure according to any of claims 1 to 13, charactenzed in that a waveguide structure encloses quantum layers or the quantum layer structure.

## Revendications

1. Structure de couches quantiques pour des laser ou des détecteurs, comportant au moins quatre couches semi-conductrices (S1, S2, S3, S4), et
- entre deux couches barrières extérieures (S1, S4) on a au moins deux couches intérieures (S2, S3),
- sans application de tension électrique, le bord inférieur de la bande de conduction de l'une des couches intérieures présente un minimum absolu pour le bord inférieur de la bande de conduction, par rapport à toutes les couches de la structure quantique, et le bord supérieur de la bande de valence d'une autre couche intérieure présente un maximum absolu pour les bords supérieurs de bandes de valence de toutes les couches de la structure quantique et
- au moins les deux couches intérieures qui présentent le minimum absolu et le maximum absolu ont des états de trous ou d'électrons quantifiés,
caractérisée en ce qu'
entre les deux couches intérieures (S2, S3) avec le maximum pour le bord supérieur de la bande de valence et le minimum pour le bord inférieur de la bande de conduction, pour lesquelles existent des états d'électrons et de trous localisés dont les fonctions propres se chevauchent, il y a au moins une autre couche (S10) servant à compenser les contraintes cristallographiques développées à l'intérieur des couches et formant un passage graduel des bords de bande entre les couches intérieures (S2, S3), pour que l'épaisseur de couche des couches intérieures (S2, S3) soit augmentée et que les longueurs d'onde d'émission et d'absorption correspondantes soient également augmentées.

2. Structure de couches quantiques selon la revendication 1,
caractérisée en ce que
les fonctions propres des états d'électrons ou de trous localisés se chevauchent suffisamment pour permettre une recombinaison avec émission entre les électrons et les trous des couches respectives.

3. Structure de couches quantiques selon la revendication 2,
caractérisée en ce que
la recombinaison est le procédé de recombinaison avec émission, dominant, dans la structure en couches.

4. Structure de couches quantiques selon l'une des revendications 1 à 3,
caractérisée en ce qu'
au moins une couche semi-conductrice est au moins partiellement pseudomorphe ou adaptée pour le réseau.

5. Structure de couches quantiques selon l'une des revendications 1 à 4,
caractérisée en ce que
les couches semi-conductrices de la structure à couches quantiques comprennent au moins deux combinaisons différentes II-VI et/ou IV-VI et/ou III-V et/ou des combinaisons du groupe IV.

6. Structure de couches quantiques selon l'une des revendications 1 à 5,
caractérisée en ce que
les couches semi-conductrices sont des combinaisons III-V.

7. Structure de couches quantiques selon l'une des revendications 1 à 6,
caractérisée en ce que
les couches semi-conductrices sont appliquées sur un substrat utilisé pour GaAs ou InP.

8. Structure de couches quantiques selon l'une des revendications 1 à 7,
caractérisée en ce que
les couches semi-conductrices comportent des combinaisons d'au moins deux des éléments suivants : Al, Ga, In, P, As et Sb.

9. Structure de couches quantiques selon l'une des revendications 1 à 8,
caractérisée en ce que
les couches semi-conductrices comprennent au moins trois des éléments suivants : Al, Ga, In, P, As et Sb.

10. Structure de couches quantiques selon l'une des revendications 1 à 9,
caractérisée en ce que
les couches semi-conductrices sont dopées.

11. Structure de couches quantiques selon l'une des revendications 1 à 10,
caractérisée en ce qu'
au moins une couche quantique est intégrée dans une structure de guide d'onde comprenant (II-IV ; III-V ; IV-VI) ou du groupe IV de manière semi-conductrice, ou des combinaisons de ces matières semi-conductrices.

12. Structure de couches quantiques selon l'une des revendications 1 à 11,
caractérisée en ce que
dans les structures de couches quantiques complètement ou partiellement pseudomorphes, on utilise des matières semi-conductrices composées chimiquement pour qu'une partie de ces couches semi-conductrices soit étendue bi-axialement et qu'une autre partie soit échangée bi-axialement.

13. Structure de couches quantiques selon l'une des revendications 1 à 12,
caractérisée par
une couche de compensation de contraintes entre les couches semi-conductrices.

14. Structure de couches quantiques selon l'une des revendications 1 à 13,
caractérisée en ce qu'
une structure de guide d'onde comprend des couches quantiques ou la structure de couches quantiques.
